# EUROPÄISCHE PATENTANMELDUNG

(11) **EP 1 349 441 A1**
(43) Veröffentlichungstag der Anmeldung: **01.10.2003**
(21) Anmeldenummer: 03006390.3
(22) Anmeldetag: 20.03.2003
(51) Int. Cl.: H05K 9/00, G06F 1/18

(54) **EMV-Kontaktierung**

(30) Priorität: 25.03.2002 DE 10213276
(71) Anmelder: Fujitsu Siemens Computers GmbH, 81739 München (DE)
(72) Erfinder: Scherer, August, 86424 Dinkelscherben (DE); Neukam, Wilhelm, 86399 Bobingen (DE)
(74) Vertreter: Epping Hermann & Fischer

(57) **Zusammenfassung**

Die Erfindung betrifft eine Anordnung zur EMV-Kontaktierung (14) zwischen zwei Einschubbaugruppen (12) in einem Einbaukäfig (1) in einem Computergehäuse (11) die im wesentlichen einen Steg (3) und ein federndes Element (5) zur Abschirmung von Störspannungen und zur Festlegung der EMV-Kontaktierung aufweist.

## Beschreibung

Die Erfindung betrifft eine Anordnung zur EMV-Kontaktierung zweier übereinanderliegender Laufwerke oder zweier nach der äußeren Form gleichartig aufgebauter Einschubbaugruppen in einem Computergehäuse.

Durch die höheren Taktfrequenzen der Rechner und der Bauteile ist es nötig, die Computergehäuse besser gegen EMV-Strahlung (EMV = elektromagnetische Verträglichkeit) abzuschirmen, da ansonsten durch die niedrigen Schaltspannungen Fehler im Rechner auftreten können.

Treten bei der EMV-Prüfung Probleme auf, ist es bisher bekannt, zwischen die Laufwerke EMV-Gaskets zu kleben.

Diese EMV-Gaskets sind zwar sehr wirkungsvoll, jedoch sind diese zum einen aufwendig bei der Montage und zum anderen ist die Montage der Einschubbaugruppen schwierig. Insbesondere muß darauf geachtete werden, daß beim Einbau die aufgeklebten EMV-Gaskets nicht abgestreift werden.

Eine weitere EMV-Kontaktierung zwischen zwei übereinanderliegender Einschubbaugruppen ist durch den Computer Scaleo 600 von Fujitsu Siemens Computers bekannt, wobei bei diesem Computer zwischen die beiden Einschubbaugruppen ein u-förmig gebogenes Blech eingesetzt wird, welches an seinen beiden Schenkeln nach innen gebogene Kontakte aufweist.

Diese Art der EMV-Kontaktierung hat den Nachteil, daß die Laufwerke voneinander durch das u-förmige Blech beabstandet sind und somit im Einbaukäfig zum einen Einbauraum verschenkt wird und zum anderen die u-förmigen Bleche zwischen den Einschubbaugruppen an der Frontseite verblendet werden müssen.

Der Erfindung liegt daher die Aufgabe zugrunde, eine EMV-Kontaktierung zwischen zwei übereinanderliegenden Laufwerken oder Einschubbaugruppen in einem Computergehäuse aufzuzeigen, welche die oben aufgeführten Nachteile vermeidet.

Die Aufgabe wird erfindungsgemäß dadurch gelöst, daß die EMV-Kontaktierung einen Steg über die Breite der Einschubbaugruppe aufweist und an dem Steg ein federndes Element zur EMV-Abschirmung ausgebildet ist.

Gemäß einer Ausführungsform der Erfindung kann der Steg mit dem federnden Element nachträglich zwischen die beiden Laufwerke eingesteckt werden. Vorteilhaft ist, daß die Laufwerke nicht größer voneinander beabstandet werden müssen, da der Steg als Blech ausgeführt ist. Bei neuen Computergehäusen kann der Einbau durch spezielle Führungsschlitze im Computergehäuse beziehungsweise im Einbaukäfig vereinfacht werden. Des weiteren können an den Führungsschlitzen auch Rastmittel zur zusätzlichen Festlegung der Anordnung ausgebildet sein.

Das federnde Element zur sicheren EMV-Abschirmung ist gemäß einer Ausführungsform als Kamm ausgebildet, dessen Zinken abwechselnd nach oben und unten gebogen sind.

Alternativ kann das federnde Element ebenso einer um den Steg gebogenen Aufsteckfeder oder einem u-förmigen EMV-Gasket, welches ebenso auf den Steg aufsteckbar ist, gebildet sein.

Wie bereits oben erwähnt, kann der Steg mit aufgestecktem oder daran angeordnetem federnden Element entweder getrennt vom Computergehäuse oder einstückig mit dem Computergehäuse hergestellt sein. Anstatt dem Computergehäuse kann auch eine einstückige Ausbildung mit dem Einbaukäfig oder der Frontblende des Computergehäuses erfolgen. Die einstückige Herstellung des Steges mit Computergehäuse, Einbaukäfig oder Frontblende hat den Vorteil, daß der Montageaufwand sinkt, da die EMV-Kontaktierung nicht nachträglich erzielt werden muß und zum anderen das beim Endverbraucher der Steg mit EMV-Kontaktierung nicht verloren gehen kann.

Die Erfindung wird nachfolgend an einem Ausführungsbeispiel anhand der Zeichnungen erläutert.

In den Zeichnungen zeigen:
- Figur 1: eine Schrägansicht eines Teiles des Computergehäuses und einer EMV-Kontaktierung,
- Figur 2: eine Schrägansicht und eine Abwicklung einer einstückig mit einem Computergehäuse hergestellten EMV-Kontaktierung
- Figur 3: eine Seitenansicht der EMV-Kontaktierung gemäß Figur 2,
- Figur 4: eine Seitenansicht einer EMV-Kontaktierung mit Gasket,
- Figur 5: eine Seitenansicht einer EMV-Kontaktierung mit Aufsteckfeder,
- Figur 6: eine Schrägansicht des nach innen gebogenen Steges zum Aufstecken von EMV-Mitteln entsprechend Figur 3,4 und 5.

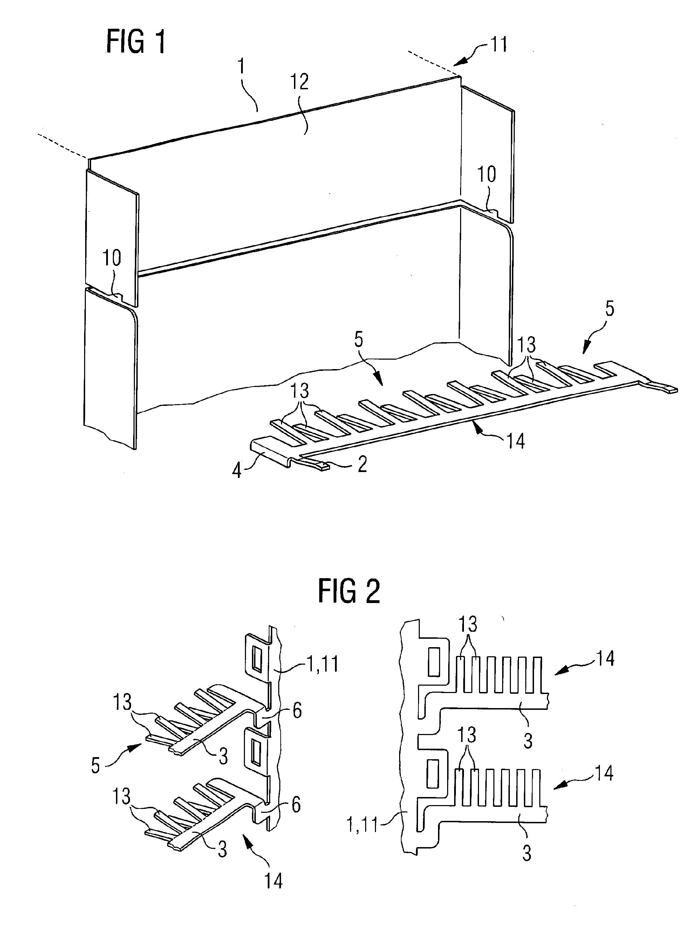

Figur 1 zeigt einen Einbaukäfig 1 eines Computergehäuses 11 mit Einschubbaugruppe 12 und einer erfindungsgemäßen EMV-Kontaktierung 14. Sie besteht im wesentlichen aus einem Steg 3, der sich über die gesamte Breite der Einschubbaugruppe 12 erstreckt, und einem federnden Element 5 das aus nach oben und unten gebogenen Zinken 13 besteht.

An jeder Seite des Steges 3 sind eine Seitenblende 4 als seitliche Fixierung und ein Rastmittel 2 zur Festlegung der EMV-Kontaktierung 14 ausgebildet.

An den hervorstehenden Seiten des Einbaukäfigs 1 ist je eine Gegenrast 10 ausgebildet, mit der das Rastmittel 2 an dem Steg 3 in eingeschobenem Zustand zusammenwirkt.

Die Zinken 13, die Seitenblenden 4 und die Rastmittel 2 sind einstückig mit dem Steg 3 hergestellt.

Figur 2 zeigt eine EMV-Kontaktierung 14 die einstückig mit dem Computergehäuse 11, der Frontblende des Computergehäuses 11 oder mit dem Einbaukäfig 1 der Einschubbaugruppe 12 hergestellt ist.

Der Steg 3 ist über einen Verbindungssteg 6 mit dem Computergehäuse 1 verbunden. Der Steg 3 wird am Übergang zu dem Verbindungssteg um 90° nach hinten gebogen.

An dem Steg 3 werden die Zinken 13 abwechselnd nach oben und unten gebogen, so daß die Einschubbaugruppen 12 von vorne eingeschoben werden können.

Des weiteren zeigt Figur 2 auch eine Abwicklung des Blechausschnittes, wobei seitlich zwischen den Stegen die Rastaussparungen zur Festlegung der Laufwerksschienen angeordnet sind.

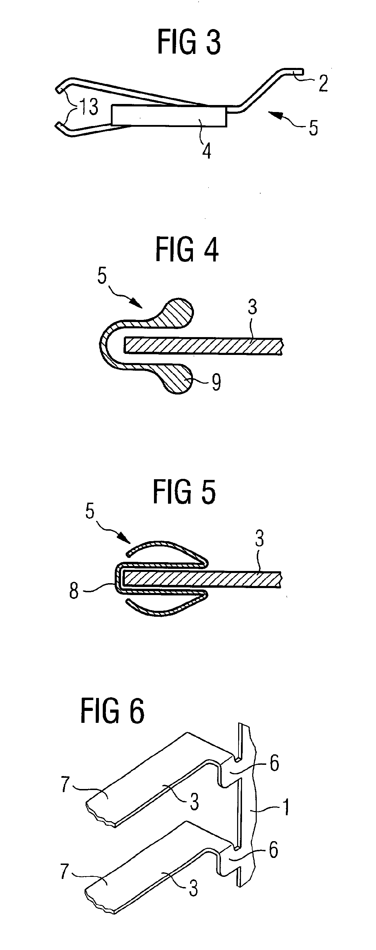

Figur 3 zeigt eine Seitenansicht EMV-Kontaktierung gemäß Figur 1. Die Spitzen der Zinken 13 sind so umgebogen, daß die Einschubbaugruppen 12 leicht aus dem Einbaukäfig 1 herausgezogen werden können.

Figur 4 zeigt eine EMV-Kontaktierung 14, bei der auf den Steg 3 ein U-förmiges EMV-Gasket 9 gesteckt ist, das sowohl zur Abschirmung gegen Störspannungen dient, als auch als federndes Element 5 wirkt.

Figur 5 zeigt eine weitere Ausführungsform der Erfindung, bei der den Steg 3 eine Aufsteckfeder 8 geschoben ist. Diese dient ebenso wie die Zinken 13 und das Gasket 9 der EMV-Abschirmung von Störspannungen und der Festlegung des Steges 3.

Die Aufsteckfeder 8 ist u-förmig um den Steg 3 gebogen und die freien Enden der Aufsteckfeder sind nach außen gewölbt wieder um 180° zurückgebogen.

Figur 6 zeigt eine einstückige Ausführungsform der EMV-Kontaktierung 14. Der Steg 3 ist einstückig mit der Frontblende des Computergehäuses 11, mit dem Computergehäuse 11 selbst oder mit dem Einbaukäfig 1 hergestellt.

Der Steg 3 dient zur Aufnahme von federnden Zusatzelementen, wie sie in den Figuren 3, 4 und 5 dargestellt sind.

Durch den Einsatz der federnden Zusatzelemente wird eine über die Lebensdauer sichere Kontaktierung gewährleistet.

### Bezugszeichenliste

- 1: Einbaukäfig
- 2: Rastmittel
- 3: Steg
- 4: Seitenblende
- 5: federndes Element
- 6: Verbindungssteg
- 7: Blechschiene
- 8: Aufsteckfeder
- 9: EMV-Gasket
- 10: Gegenrast
- 11: Computergehäuse
- 12: Einschubbaugruppe
- 13: Zinken
- 14: EMV-Kontaktierung

## Patentansprüche

1. Anordnung zur Kontaktierung zweier übereinander liegender Laufwerke oder zweier nach der äußeren Form gleichartig aufgebauten Einschubbaugruppen (12) in einem Computergehäuse (11),
**dadurch gekennzeichnet, dass** die EMV-Kontaktierung (14) einen Steg (3) über die Breite der Einschubbaugruppen (12) aufweist und an dem Steg (3) ein federndes Element (5) zur EMV-Abschirmung ausgebildet ist.

2. Anordnung nach Anspruch 1
**dadurch gekennzeichnet, dass** das federnde Element (5) aus abwechselnd nach oben und unten gebogenen Zinken (13) gebildet ist .

3. Anordnung nach Anspruch 1
**dadurch gekennzeichnet, dass** das federnde Element (5) eine gewölbte Ausbildung des Steges (3) ist.

4. Anordnung nach Anspruch 1
**dadurch gekennzeichnet, dass** das federnde Element (5) aus einer um den Steg (3) gebogenen Aufsteckfeder (8) gebildet ist.

5. Anordnung nach Anspruch 1
**dadurch gekennzeichnet, dass** das federnde Element (5) aus einem U-förmigen EMV-Gasket (9) gebildet ist.

6. Anordnung nach einem der Ansprüche 1 bis 5
**dadurch gekennzeichnet, dass** der Steg (3) durch das federnde Element (5) zwischen zwei Einschubbaugruppen (12) festlegbar ist.

7. Anordnung nach einem der Ansprüche 1 bis 6
**dadurch gekennzeichnet, dass** der Steg (3) ein Rastmittel (2) aufweist, das mit einer entsprechenden Gegenrast (10) am Computergehäuse (11) festlegbar ist.

8. Anordnung nach einem der Ansprüche 1 bis 7
**dadurch gekennzeichnet, dass** der Steg (3) an einem Einbaukäfig (1) der Einschubbaugruppe (12) oder einer speziell ausgestalteten Frontblende des Computergehäuses (11) festlegbar ist.

9. Anordnung nach Anspruch 8
**dadurch gekennzeichnet, dass** der Steg (3) einstückig mit dem Computergehäuse (11) oder dem Einbaukäfig (1) der Einschubbaugruppe (12) hergestellt ist.
